# EUROPEAN PATENT APPLICATION

(11) **EP 2 106 007 A1**
(43) Date of publication of application: **30.09.2009**
(21) Application number: 09155127.5
(22) Date of filing: 13.03.2009
(51) Int. Cl.: H02G 11/00, H05K 7/14, F16L 3/015

(54) **Cable management apparatus and method for managing cables of an electronic apparatus**

(30) Priority: 28.03.2008 JP 2008087507
(71) Applicant: Fujitsu Limited, Kawasaki-shi, Kanagawa 211-8588 (JP)
(72) Inventor: Ueda, Kengo, Kawasaki-shi Kanagawa 211-8588 (JP)
(74) Representative: Ward, James Norman

(57) **Abstract**

A cable management apparatus (23) for holding a cable. The cable management apparatus includes a first hinge member (46) supported by a first hinge shaft (45) in a rotatable manner around the first hinge shaft (45) and a coupling member (51) separably fixed to the first hinge member (46). The coupling member includes a second hinge shaft (55) parallel to the first hinge shaft (45) and disposed at a position apart from the first hinge shaft (45). The second hinge member (63) is rotatably connected to a third hinge shaft (62) parallel to the first hinge shaft (45) at a connecting edge. The second hinge member (63) includes a fourth hinge shaft (68) parallel to the first hinge shaft (45) and disposed at a position apart from the third hinge shaft (62). A middle connecting member (71) is connected to the second hinge shaft (55) at a first connecting edge and to the fourth hinge shaft (58) at a second connecting edge.

## Description

This application is based upon and claims priority to prior Japanese Patent Application No. 2008- 87507 filed on March 28, 2008 in the Japan Patent Office, the entire contents of which are incorporated herein by reference.

### BACKGROUND

### 1. Field

An embodiment of the invention discussed herein relates to a cable management apparatus for managing cables of an electronic apparatus, including a rack mount apparatus installed in a rack.

### 2. Description of the Related Art

For example, electronic apparatuses such as rack server computers are widely known. Server computers have a rack-mount computer apparatus or disk array apparatus installed in a rack. For example, a pair of right and left slide rails is attached to the rack for installing the computer apparatus or disk array apparatus. The slide rails define a housing space for the computer apparatus therebetween. The computer apparatus is slidably connected to the slide rails. The computer apparatus can be pulled out of and pushed into the housing space.
[Patent Document 1] Japanese Laid-open Patent Publication No. 2000-114744
[Patent Document 2] Japanese Laid-open Patent Publication No. 2007-234998
[Patent Document 3] Japanese Laid-open Patent Publication No. 2004-166345

### SUMMARY

According to an aspect of the invention, a cable management apparatus for holding a cable includes a first hinge member supported by a first hinge shaft in a rotatable manner around the first hinge shaft, a coupling member separably fixed to the first hinge member, the coupling member including a second hinge shaft parallel to the first hinge shaft and disposed at a position apart from the first hinge shaft, a second hinge member rotatably connected to a third hinge shaft parallel to the first hinge shaft at a connecting edge, the second hinge member including a fourth hinge shaft parallel to the first hinge shaft and disposed at a position apart from the third hinge shaft and a middle connecting member connected to the second hinge shaft at a first connecting edge and to the fourth hinge shaft at a second connecting edge.

The above-described embodiments of the present invention are intended as examples, and all embodiments of the present invention are not limited to including the features described above.

### BRIEF DESCRIPTION OF THE DRAWINGS

FIG. 1 is a view schematically depicting an appearance of an electronic apparatus according to an embodiment of the present invention;
FIG. 2 is an enlarged perspective view schematically depicting an appearance of a computer apparatus that is stored in a rack;
FIG. 3 is an enlarged perspective view schematically depicting a structure of slide rail units;
FIG. 4 is an enlarged perspective view schematically depicting an appearance of a computer apparatus that is pulled out of a rack;
FIG. 5 is an enlarged perspective view schematically depicting a structure of a cable management apparatus;
FIG. 6 is a plan view schematically depicting a state of a cable management apparatus when a computer apparatus is pulled out of a rack;
FIG. 7 is a plan view schematically depicting a state of a cable management apparatus when a computer apparatus is stored in a rack;
FIG. 8 is an enlarged perspective view of a rear panel of a computer apparatus schematically depicting a state of a cable management apparatus when a first hinge member and a coupling member are coupled to each other; and
FIG. 9 is an enlarged perspective view of a rear panel of a computer apparatus schematically depicting a state of a cable management apparatus when a first hinge member and a coupling member are separated from each other.

### DETAILED DESCRIPTION OF THE PREFERRED EMBODIMENTS

Reference may now be made in detail to embodiments of the present invention, examples of which are illustrated in the accompanying drawings, wherein like reference numerals refer to like elements throughout.

In the following, an embodiment of a cable management apparatus and an electronic apparatus disclosed herein will be described with reference to the accompanying drawings.

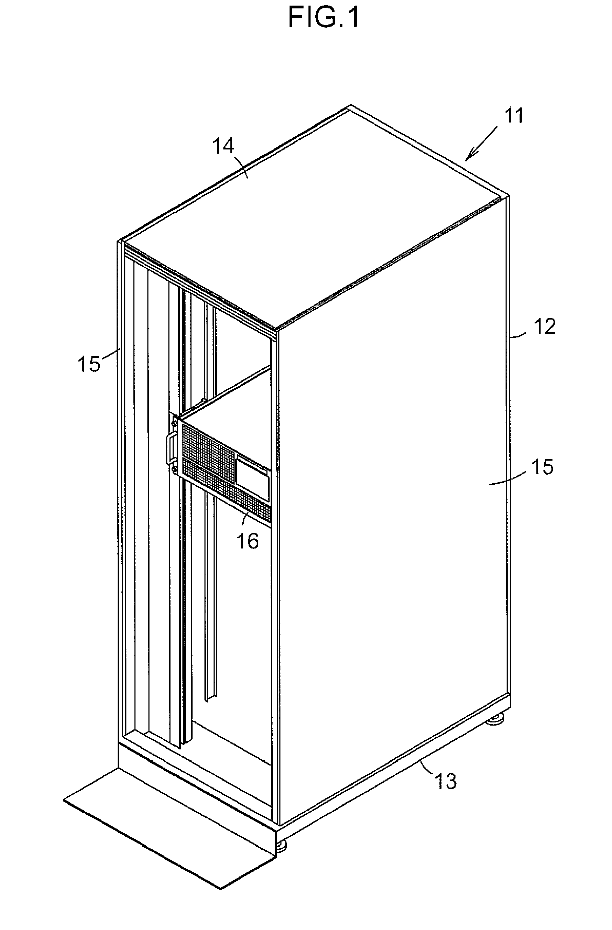

FIG. 1 is a view schematically depicting the appearance of the electronic apparatus, for example, a rack server computer 11. The server computer 11 includes a rack 12. The rack 12 includes a base 13 and a top panel 14. The base 13 and the top panel 14 extend along horizontal planes. The base 13 is installed on a floor surface. The base 13 and the top panel 14 define a rectangular parallelepiped housing space therebetween. Decorative panels 15 cover the right and left side surfaces of the housing space. A rack mount apparatus, such as a computer apparatus 16, is mounted in the rack 12. The computer apparatus 16 is housed in the housing space.

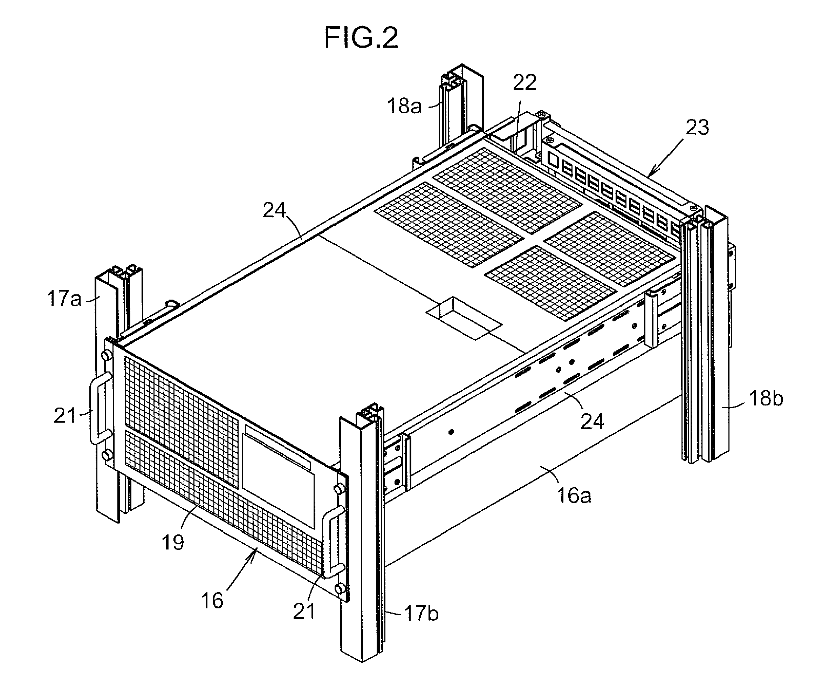

As depicted in FIG. 2, the rack 12 includes four support columns 17a, 17b, 18a, and 18b. The support columns 17a, 17b, 18a, and 18b rise from the base 13 in the vertical direction, for example. The support columns 17a, 17b, 18a, and 18b extend parallel to each other. The computer apparatus 16 includes a rectangular parallelepiped enclosure 16a. A distance between the front two support columns 17a and 17b is set to be equal to a distance between the rear two support columns 18a and 18b.

The enclosure 16a of the computer apparatus 16 is disposed between the front two support columns 17a and 17b. Similarly, the enclosure 16a of the computer apparatus 16 is disposed between the rear two support columns 18a and 18b. A pair of right and left handles 21 is attached to a front panel 19 of the computer apparatus 16. A cable management apparatus 23 is connected to a rear panel 22 of the computer apparatus 16. The cable management apparatus 23 will be described below in detail. Slide rail units 24 are respectively fixed to the left side surface and right side surface of the computer apparatus 16. The slide rail units 24 are plane-symmetrical with respect to any vertical plane.

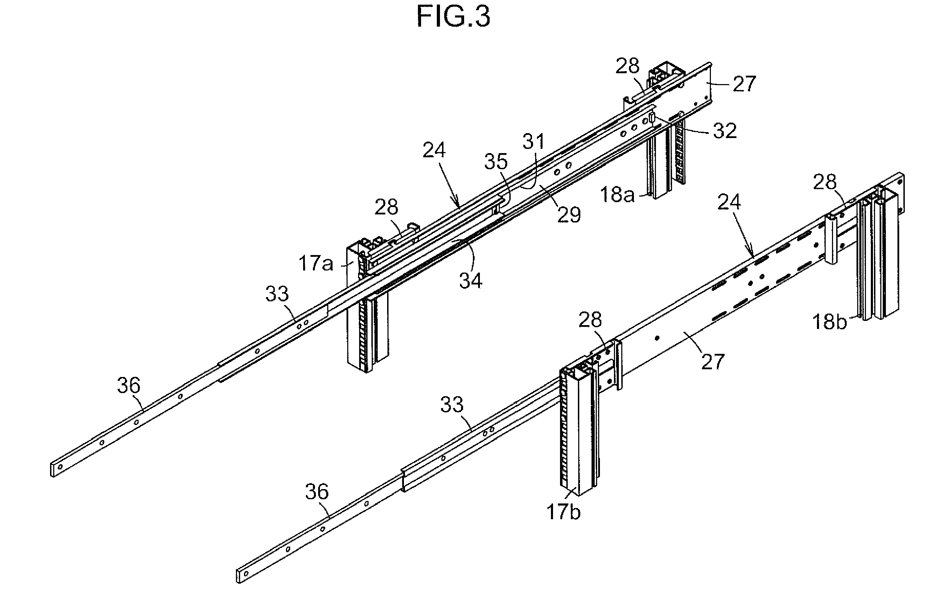

As depicted in FIG. 3, the slide rail units 24 include support members 27 respectively fixed to the front and rear two support columns 17a and 18a, and 17b and 18b. The support members 27 are disposed within a rectangular parallelepiped housing space defined by the four support columns 17a, 17b, 18a, and 18b. The support members 27 extend parallel to each other with a predetermined distance therebetween in the horizontal direction. The two support members 27 have inner surfaces facing each other. A pair of front and rear attachment members 28 is fixed to an outer surface of each of the support members 27. The attachment members 28 are respectively fixed to the corresponding support columns 17a, 17b, 18a, and 18b. The attachment members 28 are connected to the support members 27 by screws, for example.

Each of the slide rail units 24 includes a first slide rail 29. The first slide rail 29 is fixed to the inner surface of the support member 27 corresponding to the first slide rail 29. The first slide rails 29 of the two slide rail units 24 extend parallel to each other. Each of the first slide rails 29 defines a guide groove 31 that extends linearly in the horizontal direction. The guide groove 31 opens inwardly. The guide grooves 31 extend parallel to each other in the horizontal direction. A stopper 32 is formed integrally with the first slide rail 29, for example, at the rear edge of each of the guide grooves 31.

A second slide rail 33 is fitted into each of the guide grooves 31 of the first slide rails 29. The first slide rail 29 guides the second slide rail 33 corresponding to the first slide rail 29 to move in the horizontal direction. A plurality of balls may be inserted between the first slide rail 29 and the corresponding second slide rail 33, for example, in order to achieve such horizontal movement. The two second slide rails 33 extend parallel to each other. Each of the second slide rails 33 defines a guide groove 34 that extends linearly in the horizontal direction. The guide groove 34 opens inwardly. The guide grooves 34 extend parallel to each other in the horizontal direction. A stopper 35 is formed integrally with the second slide rail 33, for example, at the rear edge of each of the guide grooves 34.

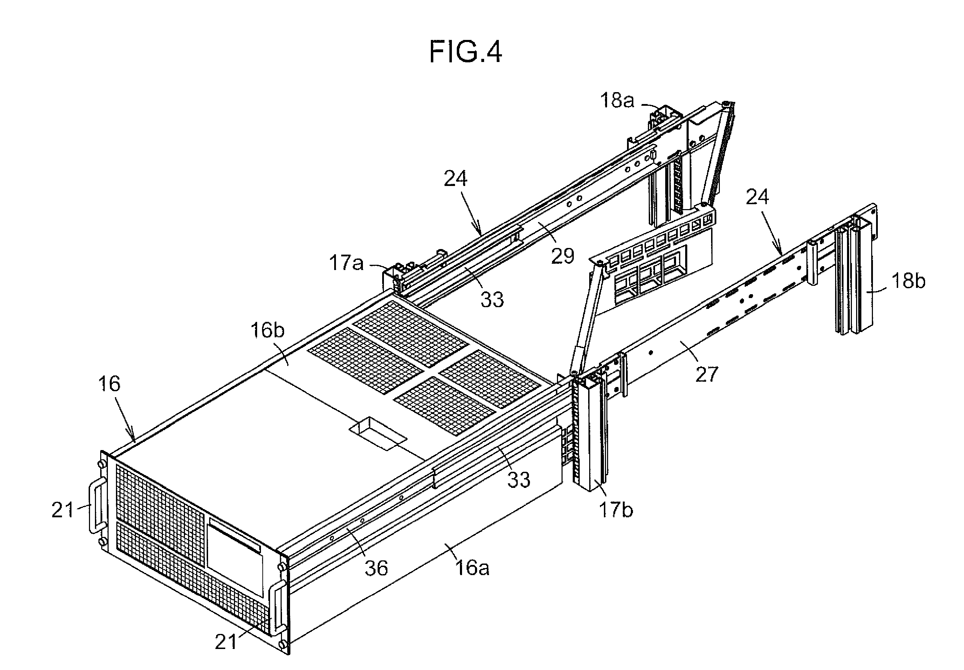

A slider 36 is fitted into each of the guide grooves 34 of the second slide rails 33. The second slide rail 33 guides the corresponding slider 36 to move in the horizontal direction. In order to achieve such horizontal movement, a plurality of balls may be inserted between the second slide rail 33 and the slider 36 corresponding to the second slide rail, for example. The two sliders 36 extend parallel to each other. As depicted in FIG. 4, the sliders 36 are fixed to the left side surface and right side surface of the computer apparatus. Screws may be used to fix the sliders 36, for example. The computer apparatus 16 is thereby disposed between the first slide rails 29, and slidably connected to the first slide rails 29.

At the same time, the computer apparatus 16 is disposed between the second slide rails 33, and slidably connected to the second slide rails 33. As a result, the computer apparatus 16 can be pulled out in the horizontal direction. Here, the computer apparatus 16 is pulled out of the rectangular parallelepiped housing space enclosed by the four support columns 17a, 17b, 18a, and 18b. An upper panel 16b of the computer apparatus 16 can be opened when the computer apparatus 16 is pulled out. When the upper panel 16b is opened, an operator can access the inside of the enclosure 16a of the computer apparatus 16 from above. The operator may use the handles 21 to pull out the computer apparatus 16, for example.

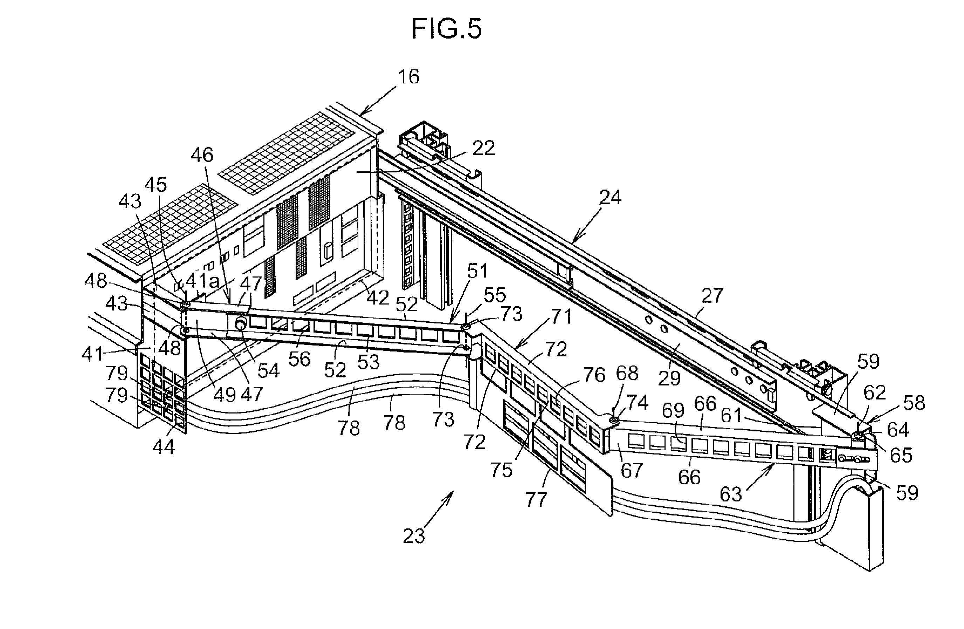

As depicted in FIG. 5, the cable management apparatus 23 includes a fixed plate 41 that is fixed to one edge, for example, the left edge of the rear panel 22 of the computer apparatus 16. The fixed plate 41 projects backward from the rear panel 22, for example. The fixed plate 41 may extend parallel to the support member 27, for example. A maintenance area 42 is defined in the rear panel 22. A connector port, a card slot, an exhaust outlet, and other openings are disposed in the maintenance area 42. The fixed plate 41 is fixed to the rear panel 22 outside the maintenance area 42. The fixed plate 41 and the slide rail unit 24 are prevented from contacting each other at the time of slide movement of the computer apparatus 16 when the computer apparatus 16 is pulled out in the horizontal direction.

The fixed plate 41 is formed from a single plate material, for example. The plate material may be formed from a stainless steel plate, for example. A pair of horizontal plate pieces 43 that extend along horizontal planes parallel to each other are defined on the plate material. Lattice openings 44 are arranged in plural rows and columns (4 rows and 4 columns, as an example) in the fixed plate 41. A lattice is defined based on the openings 44. A regulation piece 41 a is formed on the plate material. The regulation piece 41 a rises vertically from the fixed plate 41 along a vertical plane in the horizontal direction.

A first hinge member 46 is rotatably supported around a first hinge shaft 45 on the fixed plate 41. The first hinge member 46 extends in the horizontal direction from the first hinge shaft 45. The first hinge member 46 is formed from a single plate material, for example. The plate material may be formed from a stainless steel plate, for example. A pair of horizontal plate pieces 47 that extend along horizontal planes parallel to each other are defined on the plate material. The horizontal plate pieces 47 are respectively overlapped with the horizontal plate pieces 43 of the fixed plate 41.

The horizontal plate pieces 43 of the fixed plate 41 and the horizontal plate pieces 47 of the first hinge member 46 are rotatably connected to each other by screws 48, for example. Each of the screws 48 penetrates the horizontal plate piece 47 of the first hinge member 46 to be screwed into the horizontal plate piece 43 of the fixed plate 41, for example. Since the upper and lower screws 48 are coaxially disposed, the first hinge shaft 45 is established by the action of the screws 48. The shaft center of the first hinge shaft 45 extends in the vertical direction.

The horizontal plate pieces 47 are connected to each other by a vertical plate 49. The edge lines between the horizontal plate pieces 47 and the vertical plate 49 extend in the horizontal direction. The edge lines between the horizontal plate pieces 47 and the vertical plate 49 improve the rigidity of the first hinge member 46. The aforementioned regulation piece 41 a regulates the rotation of the first hinge member 46 around the first hinge shaft 45. When the vertical plate 49 of the first hinge member 46 is overlapped with the regulation piece 41 a, the first hinge member 46 adopts a posture parallel to the rear panel 22.

A long coupling member 51 is separably fixed to the first hinge member 46. The coupling member 51 extends in the horizontal direction from the first hinge member 46, for example. The coupling member 51 is formed from a single plate material, for example. The plate material may be formed from a stainless steel plate, for example. A pair of horizontal plate pieces 52 that extend along horizontal planes parallel to each other are defined on the plate material. The horizontal plate pieces 52 are disposed between the horizontal plate pieces 47 of the first hinge member 46.

The horizontal plate pieces 52 are connected to each other by a vertical plate 53. The edge lines between the horizontal plate pieces 52 and the vertical plate 53 extend in the horizontal direction. The edge lines between the horizontal plate pieces 52 and the vertical plate 53 improve the rigidity of the coupling member 51. The vertical plate 53 of the coupling member 51 is overlapped with the vertical plate 49 of the first hinge member 46 at one edge thereof, that is, a coupling edge. The vertical plate 53 of the coupling member 51 is fixed to the vertical plate 49 of the first hinge member 46 by a screw 54. A second hinge shaft 55 is formed at the other edge, that is, a free edge of the coupling member 51 at a position apart a first distance from the first hinge shaft 45. The second hinge shaft 55 will be described below in detail. A plurality of openings 56 are defined in the vertical plate 53.

On the other hand, the cable management apparatus 23 includes an attachment plate 58 that is fixed to the support member 27 of the right-side slide rail unit 24. The attachment plate 58 is formed from a single plate material, for example. The plate material may be formed from a stainless steel plate, for example. A pair of horizontal plate pieces 59 that extend along horizontal planes parallel to each other are defined on the plate material. The horizontal plate pieces 59 are connected to each other by a vertical plate 61. The edge lines between the horizontal plate pieces 59 and the vertical plate 61 extend in the horizontal direction. The vertical plate 61 is overlapped with the support member 27. The vertical plate 61 is fixed to the support member 27 by screws.

A long second hinge member 63 is rotatably supported around a third hinge shaft 62 on the attachment plate 58. The second hinge member 63 extends in the horizontal direction from the third hinge shaft 62. The second hinge member 63 is formed from a single plate material, for example. The plate material may be formed from stainless steel, for example. A pair of first horizontal plate pieces 64 that extend along horizontal planes parallel to each other are defined on the plate material. The first horizontal plate pieces 64 are respectively overlapped with the horizontal plate pieces 59 of the attachment plate 58 at one edge, that is, a connecting edge of the second hinge member 63.

The first horizontal plate pieces 64 are rotatably connected to the horizontal plate pieces 59 of the attachment plate 58 by screws 65, for example. Each of the screws 65 penetrates the first horizontal plate piece 64 of the second hinge member 63 to be screwed into the horizontal plate piece 59 of the attachment plate 58, for example. Since the screws 65 are coaxially disposed, the third hinge shaft 62 is established by the action of the screws 65. The shaft center of the third hinge shaft 62 extends in the vertical direction. That is, the shaft center of the third hinge shaft 62 extends parallel to the shaft center of the first hinge shaft 45.

A pair of second horizontal plate pieces 66 that extend along horizontal planes parallel to each other are defined on the plate material. The second horizontal plate pieces 66 extend over the entire length of the second hinge member 63. The second horizontal plate pieces 66 are connected to each other by a vertical plate 67. The edge lines between the horizontal plate pieces 66 and the vertical plate 67 extend in the horizontal direction. The edge lines between the horizontal plate pieces 66 and the vertical plate 67 improve the rigidity of the second hinge member 63. A fourth hinge shaft 68 is formed at the other edge, that is, a free edge of the second hinge member 63 at a position apart a second distance from the third hinge shaft 62. A plurality of openings 69 are formed in the vertical plate 67.

One edge, that is, a first connecting edge of a long middle connecting member 71 is connected to the second hinge shaft 55 of the coupling member 51. The other edge, that is, a second connecting edge of the middle connecting member 71 is connected to the fourth hinge shaft 68 of the second hinge member 63. The middle connecting member 71 extends in the horizontal direction between the second hinge shaft 55 and the fourth hinge shaft 68. The middle connecting member 71 is formed from a single plate material, for example. The plate material may be formed from stainless steel, for example.

A pair of horizontal plate pieces 72 that extend along horizontal planes parallel to each other are defined on the plate material. The horizontal plate pieces 72 of the middle connecting member 71 are respectively overlapped with the horizontal plate pieces 52 of the coupling member 51 at the first connecting edge. The horizontal plate pieces 72 of the middle connecting member 71 and the horizontal plate pieces 52 of the coupling member 51 are rotatably connected to each other by screws 73, for example.

Each of the screws 73 penetrates the horizontal plate piece 72 of the middle connecting member 71 to be screwed into the horizontal plate piece 52 of the coupling member 51, for example. Since the upper and lower screws 73 are coaxially disposed, the second hinge shaft 55 is established by the action of the screws 73. The shaft center of the second hinge shaft 55 extends in the vertical direction. That is, the shaft center of the second hinge shaft 55 extends parallel to the shaft center of the first hinge shaft 45. Similarly, the horizontal plate pieces 72 of the middle connecting member 71 are respectively overlapped with the second horizontal plate pieces 66 of the second hinge member 63 at the second connecting edge.

The horizontal plate pieces 72 of the middle connecting member 71 and the second horizontal plate pieces 66 of the second hinge member 63 are rotatably connected to each other by screws 74, for example. Each of the screws 74 penetrates the horizontal plate piece 72 of the middle connecting member 71 to be screwed into the second horizontal plate piece 66 of the second hinge member 63, for example. Since the upper and lower screws 74 are coaxially disposed, the fourth hinge shaft 68 is established by the action of the screws 74.

The shaft center of the fourth hinge shaft 68 extends in the vertical direction. That is, the shaft center of the fourth hinge shaft 68 extends parallel to the shaft center of the first hinge shaft 45. The horizontal plate pieces 72 are connected to each other by a vertical plate 75. The edge lines between the horizontal plate pieces 72 and the vertical plate 75 extend in the horizontal direction. The edge lines between the horizontal plate pieces 72 and the vertical plate 75 improve the rigidity of the middle connecting member 71. A plurality of openings 76 are defined in the vertical plate 75.

A cable catching member 77 is coupled to the middle connecting member 71. The cable catching member 77 guides a cable 78 parallel to the long middle connecting member 71, for example. As depicted in FIG. 5, the cable 78 is connected to the connector port, a card in the card slot, and a power connector of the rear panel 22 of the computer apparatus 16. The cable 78 is connected to the lattice of the fixed plate 41. A repeat-tie 79 may be used to connect the cable 78 to the lattice of the fixed plate 41, for example.

The lattice functions as a cable supporting mechanism. The cable 78 is subsequently received by the cable catching member 77. The cable 78 may be similarly connected to the cable catching member 77 by a repeat-tie (not depicted in FIG. 5). Thereafter, the cable 78 is connected to the attachment plate 58. A repeat-tie (not depicted in FIG. 5) may be similarly used to connect the cable 78 to the attachment plate 58, for example.

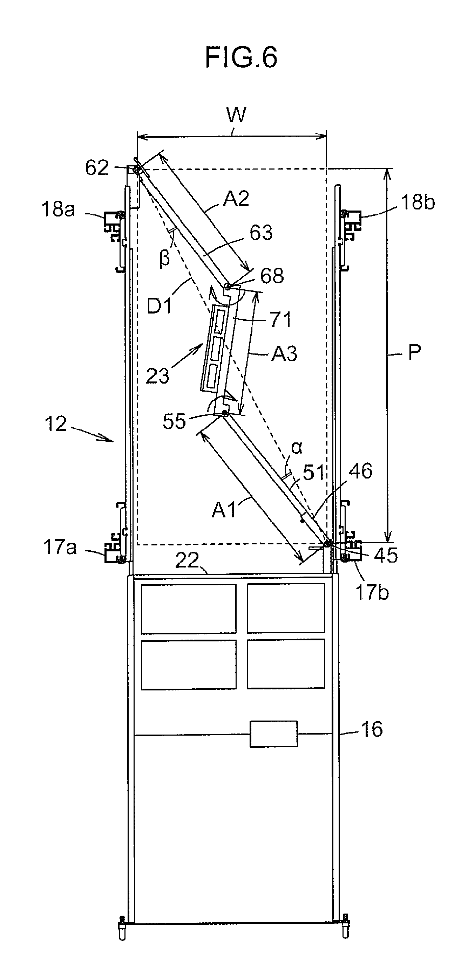

Here, a situation in which the computer apparatus 16 is stored in the rack 12 is assumed. When the computer apparatus 16 is pulled out of the rack 12 as depicted in FIG. 6, the rear panel 22 of the computer apparatus 16 is completely pulled out of the housing space enclosed by the four support columns 17a, 17b, 18a, and 18b. The shaft center of the first hinge shaft 45 is located at a front most position.

A distance D1 between the shaft center of the first hinge shaft 45 and the shaft center of the third hinge shaft 62 is given by the square root of (P2+W2). Here, W corresponds to rack width, that is, width of the computer apparatus 16. P corresponds to the perspective of the rack 12. A first distance A1 between the first hinge shaft 45 and the second hinge shaft 55 is set to be smaller than the rack width W. Similarly, a second distance A2 between the third hinge shaft 62 and the fourth hinge shaft 68 is set to be smaller than the rack width W. Again, a third distance A3 is defined as a distance between the second hinge shaft 55 and the fourth hinge shaft 68.

Furthermore, the total length of the first distance A1, the second distance A2, and a third distance A3 is set to be larger than the distance D1 described above. As a result, the first hinge member 46 and the coupling member 51 defines an acute angle α with respect to a plane including the shaft center of the first hinge shaft 45 and the shaft center of the third hinge shaft 62 as depicted in FIG. 6.

At the same time, the second hinge member 63 defines an acute angle β on the opposite side therefrom with respect to a plane including the shaft center of the first hinge shaft 45 and the shaft center of the third hinge shaft 62. Therefore, when the computer apparatus 16 is pushed into the rack 12, rotational forces are applied to the middle connecting member 71 around the second hinge shaft 55 and around the fourth hinge shaft 68 in opposite directions to each other. The coupling member 51, the middle connecting member 71, and the second hinge member 63 are thereby gradually folded.

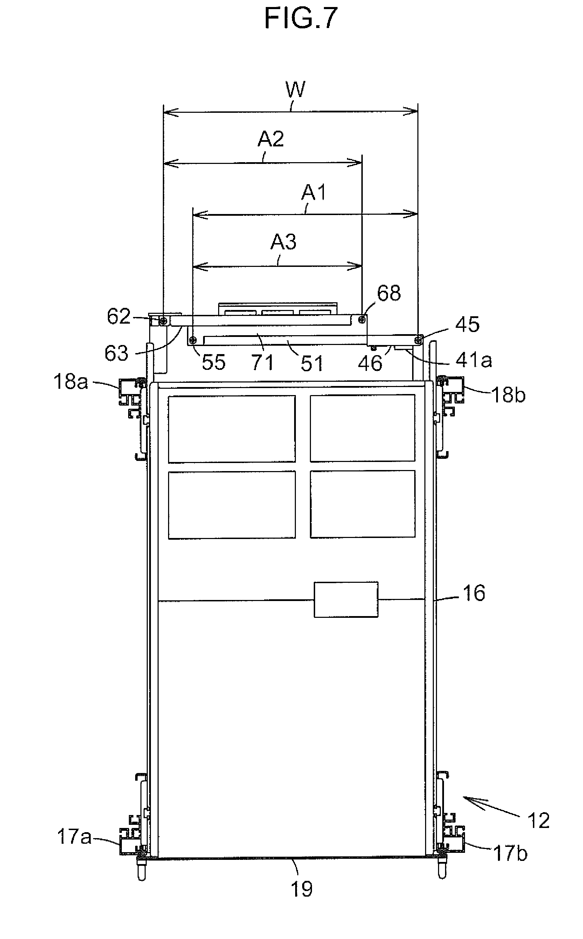

When the computer apparatus 16 is stored in the rack 12, the front panel 19 of the computer apparatus 16 is received by the front support columns 17a and 17b from outside as depicted in FIG. 7. The first hinge shaft 45 is located at a rearmost position. The relationship of W+A3=A1+A2 is established among the first distance A1, the second distance A2 and the third distance A3. Accordingly, the first hinge member 46 is received by the regulation piece 41 a.

The first hinge member 46 and the coupling member 51 are maintained in a vertical posture perpendicular to the fixed plate 41. The middle connecting member 71 is overlapped with the coupling member 51. The second hinge member 63 is overlapped with the middle connecting member 71. The coupling member 51, the middle connecting member 71, and the second hinge member 63 are folded. As a result, the coupling member 51, the middle connecting member 71, and the second hinge member 63 can be housed within a minimum occupancy space.

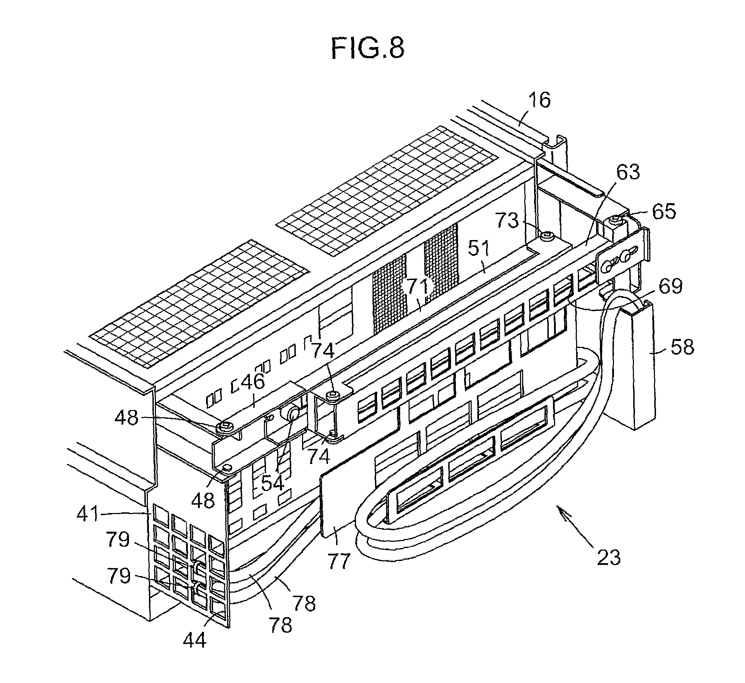

The cable 78 is housed in a position as depicted in FIG. 8. The cable 78 is reliably prevented from being entangled. At this point, the openings 56 of the coupling member 51, the openings 76 of the middle connecting member 71, and the openings 69 of the second hinge member 63 are overlapped with each other. Accordingly, an air flow from the exhaust outlet of the rear panel 22 is not blocked. Good exhaust can be ensured.

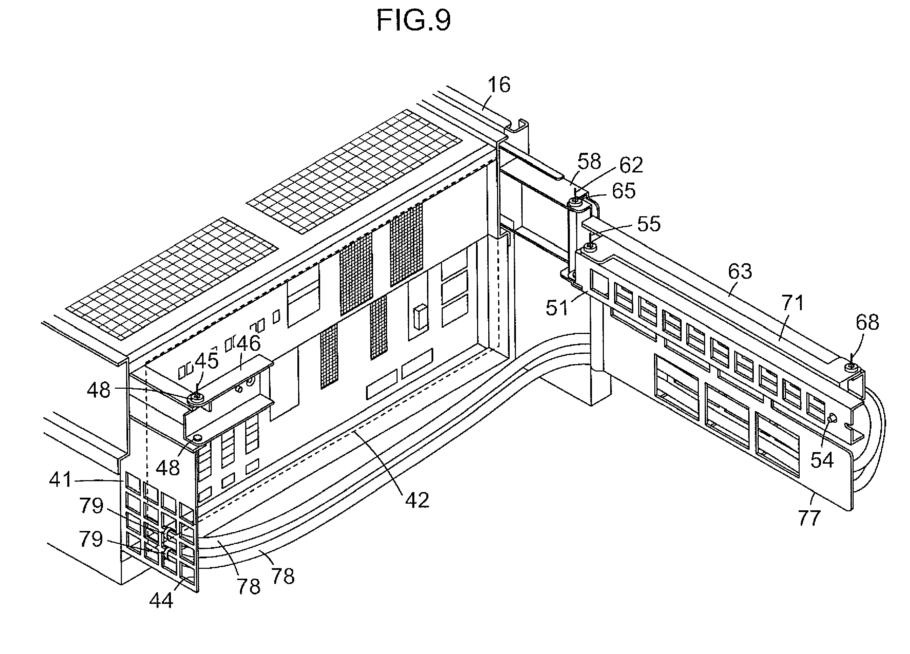

Next, a situation in which maintenance of the rear panel 22 is conducted is assumed. The coupling by the screw 54 is released between the first hinge member 46 and the coupling member 51. The coupling member 51 is thereby separated from the first hinge member 46. As depicted in FIG. 9, the second hinge member 63 can rotate around the third hinge shaft 62. The overlapping between the middle connecting member 71 and the coupling member 51 is maintained on the second hinge member 63.

Since the cable 78 is not held by the first hinge member 46 and the coupling member 51, the cable 78 is prevented from being entangled at the time of opening and closing the second hinge member 63. An operator can easily access the maintenance area 42 of the rear panel 22. The first hinge member 46 can maintain a vertical posture with respect to the fixed plate 41 because of the action of the regulation piece 41 a after the separation. Therefore, the vertical plate 53 of the coupling member 51 can be reliably overlapped with the vertical plate 49 of the first hinge member 46 at the time of re-coupling the coupling member 51 and the first hinge member 46.

The aforementioned middle connecting member 71 may be replaced with a group of middle connecting members. In the group of middle connecting members, middle connecting members may be sequentially connected in a rotatable manner around a hinge shaft parallel to the first hinge shaft 45. For example, the group of middle connecting members may include a first middle connecting member connected to the second hinge shaft 55 at the first connecting edge and having a fifth hinge shaft parallel to the first hinge shaft 45 disposed at a position apart a third distance from the second hinge shaft 55, and a second middle connecting member connected to the fourth hinge shaft 68 at the second connecting edge and connected to the fifth hinge shaft at the other edge.

Although a few preferred embodiments of the present invention have been shown and described, it would be appreciated by those skilled in the art that changes may be made in these embodiments without departing from the principles and spirit of the invention, the scope of which is defined in the claims and their equivalents.

## Claims

1. A cable management apparatus for holding a cable, the cable management apparatus comprising:
a first hinge member supported by a first hinge shaft in a rotatable manner around the first hinge shaft;
a coupling member separably fixed to the first hinge member, the coupling member including a second hinge shaft parallel to the first hinge shaft and disposed at a position apart from the first hinge shaft;
a second hinge member rotatably connected to a third hinge shaft parallel to the first hinge shaft at a connecting edge, the second hinge member including a fourth hinge shaft parallel to the first hinge shaft and disposed at a position apart from the third hinge shaft; and
a middle connecting member connected to the second hinge shaft at a first connecting edge and to the fourth hinge shaft at a second connecting edge.

2. The cable management apparatus according to claim 1, wherein the coupling member, the middle connecting member and the second hinge member are overlapped with each other in this order.

3. The cable management apparatus according to claim 2, wherein the coupling member, the middle connecting member and the second hinge member includes an opening respectively defined thereof, and the openings overlap when the coupling member, the middle connecting member and the second hinge member are overlapped with each other.

4. The cable management apparatus according to claim 1, further comprising:
a fixed plate supporting the first hinge member in a rotatable manner around the first hinge shaft; and
a cable supporting mechanism formed on the fixed plate that supports a cable.

5. The cable management apparatus according to claim 1, further comprising:
a fixed plate supporting the first hinge member in a rotatable manner around the first hinge shaft; and
a regulation piece formed on the fixed plate that regulates the rotation of the first hinge member.

6. An electronic apparatus comprising:
a rack;
a pair of slide rails separated from each other with a predetermined distance therebetween and fixed to the rack;
a rack mount apparatus disposed between the slide rails and slidably connected to the slide rails;
a first hinge member fixed to one of the rack mount apparatus, the rack and the slide rails that rotates around a first hinge shaft;
a coupling member separably fixed to the first hinge member that includes a second hinge shaft parallel to the first hinge shaft disposed at a position apart from the first hinge shaft;
a second hinge member fixed to one of the rack mount apparatus, and the rack and the slide rails except the first hinge member fixed to that rotates around a third hinge shaft parallel to the first hinge shaft, the second hinge member including a fourth hinge shaft parallel to the first hinge shaft disposed at a position apart from the third hinge shaft; and
a middle connecting member connected to the second hinge shaft at a first connecting edge and the fourth hinge shaft at a second connecting edge.

7. The electronic apparatus according to claim 6, wherein the coupling member, the middle connecting member and the second hinge member are overlapped with each other in this order.

8. The electronic apparatus according to claim 7, wherein openings overlap when the coupling member, the middle connecting member and the second hinge member are overlapped with each other and respectively defined thereof.

9. The electronic apparatus according to claim 6, further comprising a fixed plate supporting the first hinge member in a rotatable manner around the first hinge shaft, and a cable supporting mechanism formed on the fixed plate, wherein the supporting mechanism supports a cable.

10. The electronic apparatus according to claim 6, further comprising a fixed plate supporting the first hinge member in a rotatable manner around the first hinge shaft, and a regulation piece formed on the fixed plate, wherein the regulation piece regulates the rotation of the first hinge member around the first hinge shaft.

11. The electronic apparatus according to claim 6, further comprising a first middle connecting member connected to the second hinge shaft at the first connecting edge, a fifth hinge shaft formed in parallel to the first hinge shaft disposed at a position apart a third distance from the second hinge shaft and a second middle connecting member connected to the fourth hinge shaft at the second connecting edge and the fifth hinge shaft at the other edge.

12. A method of holding a cable, comprising:
supporting a first hinge member rotatably about a first hinge shaft;
disposing a second hinge shaft parallel to the first hinge shaft and apart from the first hinge shaft;
providing a coupling member including the second hinge shaft;
fixing the coupling member separably to the first hinge member;
disposing a fourth hinge shaft parallel to the first hinge shaft and apart from a third hinge shaft;
providing a second hinge member including the fourth hinge shaft;
connecting the second hinge member rotatably to the third hinge shaft at a connecting edge;
connecting a middle connecting member to the second hinge shaft at a first connecting edge; and
connecting the middle connecting member to the fourth hinge shaft at a second connecting edge.
